(19) Europäisches Patentamt

European Patent Office

Office européen des brevets

(11) **EP 2 608 403 A1**

(12) **EUROPEAN PATENT APPLICATION**

(43) Date of publication:
**26.06.2013 Bulletin 2013/26**

(21) Application number: **11306719.3**

(22) Date of filing: **21.12.2011**

(51) Int Cl.:
*H03F 3/217* (2006.01)          *H03F 1/26* (2006.01)
*H03K 7/08* (2006.01)          *H02M 7/487* (2007.01)
*H04B 15/00* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicants:
• **Alcatel Lucent
75007 Paris (FR)**
• **Friedrich-Alexander-Universität Erlangen-
Nürnberg
91054 Erlangen (DE)**

(72) Inventors:
• **Frotzscher, Andreas
01640 Coswig (DE)**
• **Haslach, Christoph
70178 Stuttgart (DE)**
• **Markert, Daniel
70435 Stuttgart (DE)**

(74) Representative: **Kleinbub, Oliver et al
Alcatel-Lucent Deutschland AG
Intellectual Property & Standards
Lorenzstrasse 10
70435 Stuttgart (DE)**

(54) **A method for signal modulation using pulse width modulators**

(57)    The invention concerns a method for signal modulation of an input signal (S) using pulse width modulators (PWM1, PWM2), wherein the input signal (S) is modulated in said pulse width modulators (PWM1, PWM2) by means of reference signals (SR, SRPS) resulting in pulse width modulated signals with two levels (SPWM1, SPWM2), and at least one of fundamentals and harmonics of a first reference signal of said reference signals (SR) comprised in a first pulse width modulated signal of said pulse width modulated signals with two levels (SPWM1) at least partially superpose destructively with at least one of fundamentals and harmonics of a second reference signal of said reference signals (SRPS) comprised in a second pulse width modulated signal of said pulse width modulated signals with two levels (SPWM2), and a transmitter therefor.

Fig. 3

EP 2 608 403 A1

**Description**

**Field of the invention**

The invention relates to a method for signal modulation of an input signal using pulse width modulators, and a transmitter adapted to perform said method.

**Background**

In order to support highly efficient switching power amplifiers, signals with continuous amplitude, or multi-level signals, need to be converted to 2-level signals. In general, this transformation is executed by so-called delta sigma modulators (DSM), also called sigma delta modulators, or pulse length modulators (PLM), also called pulse width modulators (PWM).

These so-called pulse width modulators (PWM) are promising modulator concepts in the context of switching amplifiers, e.g. for highly efficient switching power amplifiers used for the amplification of radio signals to be transmitted over an air interface in a communication network. In principle, they allow for an ideal conversion of signals with continuous amplitude and limited bandwidth to a time continuous 2-level signal. This 2-level signal is perfectly suited for switching amplifier stages. The 2-level signal can be reconverted to the continuous amplitude signal simply by a reconstruction filter after the amplification stage.

Further applications of pulse width modulators comprise the control of the supply of electrical power for other devices such as in speed control of electric motors, operation of so-called class D audio switching amplifiers or brightness control of light sources.

**Summary**

There exist numerous pulse width modulator architectures, but they either suffer from low coding efficiency, spectral deterioration, high sampling frequencies and/or difficulties in implementations. The typical class S setup employing a pulse width modulator looks as follows: an analogue signal is converted to a 2-level signal, e.g. a switching signal, by a pulse width modulator. The resulting signal is amplified by a switching amplifier. The amplified signal is reconverted to a time- and amplitude-continuous signal by a reconstruction filter, which can be a low pass or band pass filter. This filter erases, i.e. attenuates, the out-of-band signal components. If there are many and strong out-of-band signal components, also refered to as quantization noise, this results in strict requirements for the filter characteristics and the termination conditions of this filter. Any non-idealities in these characteristics result in power losses and/or spectral deterioration. Hence, it is important to have a pulse width modulator architecture, that generates a switching signal with a minimum of signal components in the out-of-band region. This means, the coding efficiency of the switching signal, defined as the ratio of the wanted signal power at the carrier frequency and the total signal power, shall be as high as possible.

In general, a pulse width modulator can achieve much better spectral purity and better coding efficiency than a delta sigma modulator. A delta sigma modulator generates a bit sequence at fixed bitrate, and allows signal regeneration with a simple clock data recovery unit. A pulse width modulator generates a binary sequence where each pulse may have an arbitrary pulse length or discrete pulse length with fine granularity within a certain range. Hence, clock recovery is not possible or only possible with very high effort in the case of discrete pulse widths.

In principle, an analogue implementation of a pulse width modulator works as described in the following.

A signal with a continuous amplitude is fed to a comparator as a first input signal. The second input signal to the comparator is a sawtooth signal or a triangular signal. In the following only the sawtooth signal is mentioned, but the considerations are valid for triangular signals too. As soon as the ascending amplitude of the sawtooth signal has the same value as the continuous amplitude signal, the output of the comparator switches from voltage-high (VH) to voltage-low (VL). The falling edge of the sawtooth signal resets the output of the comparator to voltage-high (VH). The output of the comparator is the PWM signal. Without loss of generality, the values VH and VL may be chosen to arbitrarily different levels to modify the properties of the PWM output signal.

Depending on the implementation, the first input signal of the comparator may also be the sampled version of the continuous amplitude signal, sampled at equidistant time instances.

Simulation results of such a pulse width modulator according to the state of the art for a 5MHz UMTS signal (UMTS = Universal Mobile Telecommunications System) with 5 MHz bandwidth, and with the carrier frequency of the UMTS signal being 900 MHz, and the repetition frequency of the triangular trigger signal, i.e. reference signal, being 2 GHz, show that the wanted signal at 900 MHz only contains a small fraction of the total signal power. The majority of signal power is allocated at the fundamental component of the reference signal at 2 GHz. As a consequence, the coding efficiency is only 11.98% in this case.

The object of the invention is thus to propose a method for signal modulation based on pulse width modulation that has high coding efficieny, low pulse rates and a simple structure that improves energy efficiency.

The basic idea of the invention is to generate a second additional pulse width modulator signal that comprises the information signal, and a fundamental and harmonics of the reference signal such that by adding the two pulse width modulator signals the information signals superpose constructively and at least one of the group of the fundamentals and the harmonics of the reference signals, the harmonics of the information signal, and intermodulation products of the reference signals and the information signals at least partially cancel out each other. Consequently, the combined pulse width modulator output signal is a ternary signal, i.e. a 3-level signal. In an embodiment of the invention, in order to cancel out said at least one of the group of the fundamentals and the harmonics of the reference signals, the harmonics of the information signal, and inter-modulation products of the reference signals and the information signals, the reference signals of the two pulse width modulators are inversely phased, e.g. by means of inserting a 180° phase shifter.

In the following, for the sake of simplicity sometimes only cancelling out of the fundamentals and the harmonics of the reference signals is mentioned, however in these cases, also at least partially cancelling out of at least one of the group of the fundamentals and the harmonics of the reference signals, the harmonics of the information signal, and intermodulation products of the reference signals and the information signals shall be comprised.

Simulations show that applying said method according to the invention leads to the highest power spectral density being now located at the wanted carrier frequency at 900 MHz, and that the unwanted spectral component at the repetition frequency of the reference signal at 2 GHz is severely attenuated compared to output signals generated with only a single pulse width modulator. The coding efficiency is 42.7% now using a combined pulse width modulator output signal for the above-described UMTS signal with 5.6dB PAPR, compared to 11.98% using a single pulse width modulator according to the state of the art for the same input signal.

The object is thus achieved by a method for signal modulation of an input signal using pulse width modulators, wherein

- the input signal is modulated in said pulse width modulators by means of reference signals resulting in pulse width modulated signals with two levels,

- and at least one of a group of fundamentals and harmonics of a first reference signal of said reference signals and intermodulation products of said first reference signal and the input signal comprised in a first pulse width modulated signal of said pulse width modulated signals with two levels at least partially superpose destructively with at least one of a group of fundamentals and harmonics of a second reference signal of said reference signals and intermodulation products of said second reference signal and the input signal comprised in a second pulse width modulated signal of said pulse width modulated signals with two levels.

The object is furthermore achieved by a transmitter comprising pulse width modulators for signal modulation of an input signal, wherein said pulse width modulators are adapted to modulate the input signal by means of reference signals resulting in pulse width modulated signals with two levels in such a way, that at least one of a group of fundamentals and harmonics of a first reference signal of said reference signals and intermodulation products of said first reference signal and the input signal comprised in a first pulse width modulated signal of said pulse width modulated signals with two levels at least partially superpose destructively with at least one of a group of fundamentals and harmonics of a second reference signal of said reference signals and intermodulation products of said second reference signal and the input signal comprised in a second pulse width modulated signal of said pulse width modulated signals with two levels.

Further features and advantages are stated in the following description of exemplary embodiments, with reference to the figures, which show significant details, and are defined by the claims. The individual features can be implemented individually by themselves, or several of them can be implemented in any desired combination.

**Brief description of the figures**

In the following the invention will be explained further making reference to the attached drawings.

Fig. 1 schematically shows a pulse width modulator according to the state of the art.

Fig. 2 schematically shows input signals, output signals and sawtooth reference signals of a pulse width modulator according to the state of the art.

Fig. 3 schematically shows exemplarily a transmitter comprising two pulse width modulators for signal modulation of an input signal according to an embodiment of the invention.

Fig. 4 schematically shows input signals, output signals and sawtooth reference signals of a first pulse width modulator and of a second pulse width modulator with phase shifted sawtooth reference signals according to an embodiment of the invention.

Fig. 5 shows a spectrum plot of a power spectral density of a first pulse width modulated signal generated in a first pulse width modulator with a triangular reference signal depicted in the upper diagram in fig. 4.

Fig. 6 shows a spectrum plot of a power spectral density of a second pulse width modulated signal generated in a second pulse width modulator with a phase shifted triangular reference signal depicted in the lower diagram in fig. 4.

Fig. 7 shows a spectrum plot of a power spectral density of the combined first and second pulse width modulated signals depicted in fig. 4.

Fig. 8 shows in the time domain an analogue input signal, a first pulse width modulated signal generated in a first pulse width modulator with a reference signal, and a second pulse width modulated signal generated in a second pulse width modulator with a phase shifted reference signal.

Fig. 9 shows in the time domain an analogue input signal, and the sum of a first pulse width modulated signal generated in a first pulse width modulator with a reference signal and a second pulse width modulated signal generated in a second pulse width modulator with a phase shifted reference signal.

Fig. 10 schematically shows exemplarily a transmitter for signal modulation of an input signal comprising two pulse width modulators using sinusoidals for approximation of a triangular reference signal according to an embodiment of the invention.

Fig. 11 schematically shows exemplarily a transmitter comprising two pulse width modulators for signal modulation of an input signal and two switching power amplifiers for amplification of modulated signals according to an embodiment of the invention.

Fig. 12 schematically shows exemplarily a transmitter comprising two pulse width modulators for signal modulation of an input signal, an inverter and a differential switching power amplifier for amplification of modulated signals according to an embodiment of the invention.

Fig. 13 schematically shows exemplarily a transmitter comprising two pulse width modulators for signal modulation of an input signal, and a differential switching power amplifier for amplification of modulated signals according to an embodiment of the invention.

Fig. 14 schematically shows a differential switching power amplifier architecture relying on a voltage switched circuit topology according to the state of the art.

Fig. 15 schematically shows a differential switching power amplifier architecture relying on a current switched circuit topology according to the state of the art.

Fig. 16 schematically shows exemplarily a transmitter comprising two pulse width modulators for signal modulation of an input signal, and a H-bridge power amplifier according to an embodiment of the invention.

Fig. 17 schematically shows exemplarily a transmitter comprising two pulse width modulators for signal modulation of an input signal, an inverter, a logic circuit, and a differential switching power amplifier for amplification of modulated signals according to an embodiment of the invention.

Fig. 18 schematically shows exemplarily a transmitter comprising two pulse width modulators for signal modulation of an input signal, a logic circuit, and a differential switching power amplifier for amplification of modulated signals according to an embodiment of the invention.

Fig. 19 schematically shows exemplarily a transmitter comprising two pulse width modulators for signal modulation of an input signal, two electro-optical converters and an optical combiner for optical transmission of pulse width modulated signals according to an embodiment of the invention.

Fig. 20 schematically shows exemplarily a transmitter according to fig. 13, with additionally two electro-optical converters and two opto-electrical converters for optical transmission of pulse width modulated signals to the differential switching power amplifier according to an embodiment of the invention.

**Description of the embodiments**

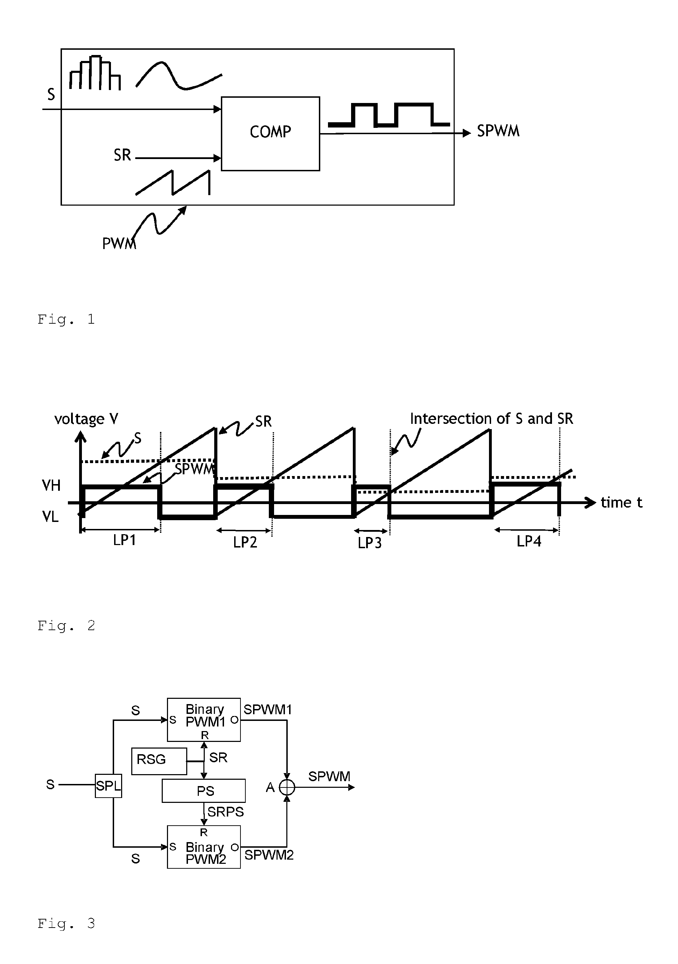

Fig. 1 schematically shows a pulse width modulator PWM according to the state of the art comprising as a basic part a comparator COMP with two inputs and one output.

Depending on the implementation, the input signal S of the pulse width modulator PWM can either be a signal with continuous amplitude, or the sampled version of the continuous amplitude signal, sampled at equidistant time instances.

The input signal S is fed to the first input of the comparator COMP, and a sawtooth signal SR is fed as reference signal to the second input of the comparator COMP. As soon as the ascending amplitude of the sawtooth signal SR has the same value as the input signal S, the output of the comparator switches from voltage-high (VH) to voltage-low (VL) and remains at VL as long as $SR \geq S$ holds. The falling edge of the sawtooth signal SR resets the output of the comparator to voltage high (VH). The pulse width modulated signal SPWM is transmitted from the output of the comparator COMP to the output of the pulse width modulator PWM.

Fig. 2 schematically shows such input signals S, output signals SPWM and sawtooth signals SR of a pulse width modulator according to the state of the art as depicted in fig. 1.

In the diagram in fig. 2, the voltage V of a sampled version of the continuous amplitude input signal S, a pulse width modulated output signal SPWM and a sawtooth signal SR are plotted against the time t.

As soon as the ascending amplitude of the sawtooth signal SR has the same value as the continuous amplitude input signal S, or as the sampled version of the continuous amplitude input signal S, the output of the comparator COMP in fig. 1 switches from voltage-high VH to voltage-low VL. The falling edge of the sawtooth signal SR resets the output of the comparator COMP to voltage-high VH. The output signal of the comparator COMP is the pulse width modulated signal SPWM comprising pulses of different length LP1-LP4.

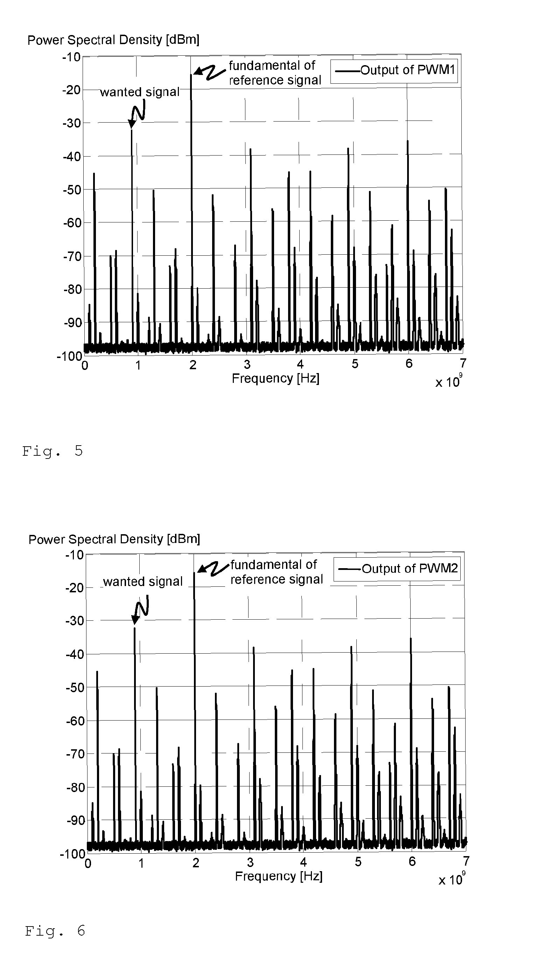

The basic idea of the invention is to generate a second additional pulse width modulated signal that also comprises the input signal S and a fundamental and harmonics of the reference signal SR such that by adding the two pulse width modulated signals the input signals comprising desired information superpose constructively, and amongst others the fundamentals and the harmonics of the reference signals SR at least partially cancel out each other, which is shown in figs. 5, 6 and 7 and described in detail below. Consequently, the combined pulse width modulated output signal which results from a combination of the two pulse width modulated signals is a ternary signal, i.e. a 3-level signal.

In an embodiment of the invention, in order to cancel out the fundamentals and the harmonics of the reference signals, the reference signals of two pulse width modulators are inversely phased, e.g. by means of inserting a 180° phase shifter.

Fig. 3 schematically shows exemplarily a transmitter comprising two pulse width modulators for signal modulation of an input signal according to said embodiment of the invention.

The transmitter comprises a splitter or coupler SPL, a first and a second pulse width modulator PWM1, PWM2, a reference signal generator RSG, a phase shifter or delay element PS, and an adder A.

An input signal S is duplicated by means of the splitter or coupler SPL. As in the embodiment in fig. 3 only the functionality of a splitter is required, the usage of a splitter SPL is preferred.

The input signal S is transmitted to a signal input of the first pulse width modulator PWM1, and a reference signal SR generated in the reference signal generator RSG is fed to a reference input of the first pulse width modulator PWM1. As depicted in figs. 1, 2 and 4, and described above and in the following respectively, a first pulse width modulated signal SPWM1 results from a comparison of the input signal S with the reference signal SR, and said first pulse width modulated signal SPWM1 is sent to a first input of the adder A.

The input signal S is also transmitted to a signal input of the second pulse width modulator PWM2, and the reference signal SR generated in the reference signal generator RSG is phase shifted in the phase shifter or delay element PS resulting in a phase shifted reference signal SRPS which is fed to a reference input of the second pulse width modulator PWM2. As depicted in figs. 1, 2 and 4, and described above and in the following respectively, a second pulse width modulated signal SPWM2 results from a comparison of the input signal S with the phase shifted reference signal SRPS, and said second pulse width modulated signal SPWM2 is sent to a second input of the adder A.

The phase shifter or delay element PS can e.g. be realized by a fixed delay line which is inserted in the signal path, or by an adjustable delay line which is realized by a mechanical construction allowing to feed or to tap a signal at an arbitrary and tunable point of a delay line.

The first pulse width modulated signal SPWM1 and the second pulse width modulated signal SPWM2 are added in the adder A resulting in a ternary pulse width modulated signal SPWM.

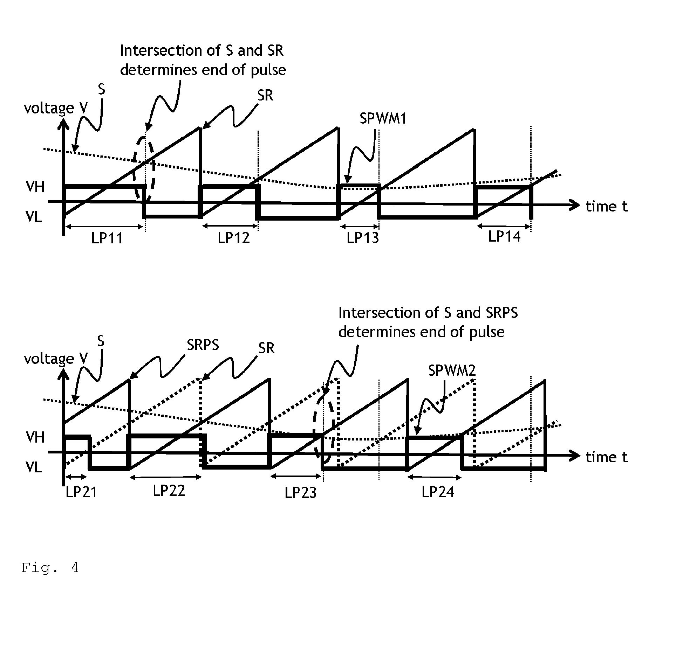

In the upper diagram in fig. 4, the voltage V of the input signal S, the pulse width modulated output signal SPWM1 of the first pulse width modulator PWM1, and the sawtooth reference signal SR as depicted in fig. 3 and described above are plotted against the time t.

As soon as the ascending amplitude of the sawtooth reference signal SR has the same value as the input signal S, the output of the first pulse width modulator PWM1 switches from voltage-high VH to voltage-low VL. The falling edge of the sawtooth reference signal SR resets the output of the first pulse width modulator PWM1 to voltage-high VH. The output signal of the first pulse width modulator PWM1 is the first pulse width modulated signal SPWM1 comprising pulses of different length LP11-LP14.

In the lower diagram in fig. 4, the voltage V of the input signal S, the pulse width modulated output signal SPWM2 of the second pulse width modulator PWM2, and the phase shifted sawtooth reference signal SRPS as depicted in fig. 3 and described above are plotted against the time t. The phase shift between the sawtooth reference signal SR used in the first pulse width modulator PWM1, and the phase shifted sawtooth reference signal SRPS used in the second pulse width modulator PWM2 is 180° in the embodiment.

As soon as the ascending amplitude of the phase shifted sawtooth reference signal SRPS has the same value as the input signal S, the output of the second pulse width modulator PWM2 switches from voltage-high VH to voltage-low VL. The falling edge of the phase shifted sawtooth reference signal SRPS resets the output of the second pulse width modulator PWM2 to voltage-high VH. The output signal of the second pulse width modulator PWM2 is the second pulse width modulated signal SPWM2 comprising pulses of different length LP21-LP24.

Fig. 5 shows a simulation of a spectrum plot of a power spectral density of the first pulse width modulated signal SPWM1 generated in the first pulse width modulator PWM1 depicted in fig. 3 with a triangular reference signal SR and with a UMTS input signal S with 5 MHz bandwidth and 5.6dB PAPR (PAPR = Peak-to-Average Power Ratio). The carrier frequency of the UMTS signal is 900 MHz, and the repetition frequency of the triangular trigger signal, i.e. reference signal SR, is 2 GHz. The information signal at 900 MHz, i.e. the input signal S, can be seen as spike, and the fundamental of the 2 GHz reference signal SR results in a very strong spike at 2 GHz. This spike at 2 GHz contains the majority of the output signal power of PWM1.

Fig. 6 shows a simulation of a spectrum plot of a power spectral density of the second pulse width modulated signal SPWM2 generated in the second pulse width modulator PWM2 depicted in fig. 3 with a phase shifted triangular reference signal SRPS and with a UMTS input signal S with 5 MHz bandwidth and 5.6dB PAPR. The carrier frequency of the UMTS signal is 900 MHz, and the repetition frequency of the triangular trigger signal, i.e. phase shifted reference signal SRPS, is 2 GHz. The information signal at 900 MHz, i.e. the input signal S, can be seen as spike, and the fundamental of the 2 GHz reference signal SR results in a very strong spike at 2 GHz. This spike at 2 GHz contains the majority of the output signal power of PWM1. It can be seen that the spectrum depicted in fig. 6 has a very similar shape as the spectrum depicted in fig. 5.

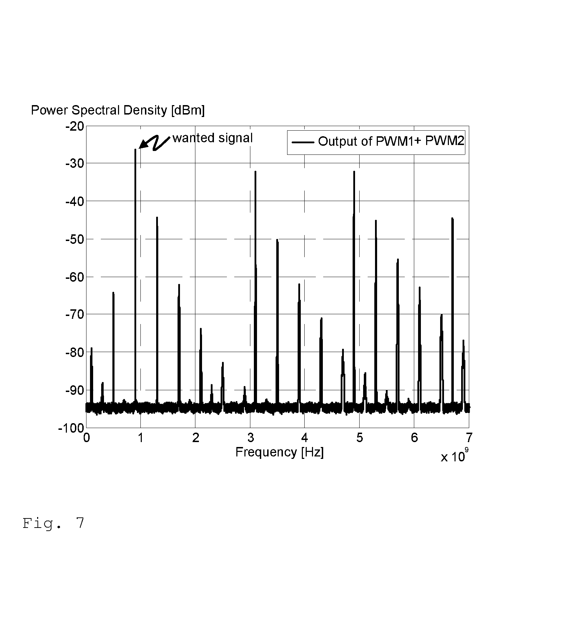

Fig. 7 shows a simulation of a spectrum plot of a power spectral density of the combined first and second pulse width modulated signals SPWM1 and SPWM2 depicted in fig. 3 and fig. 4. It can be seen that the unwanted spectral component at 2 GHz is severely attenuated compared to the power spectral density of the output signals SPWM1 and SPWM2 of the single pulse width modulators PWM1 and PWM2 depicted in fig. 5 and fig. 6. This results in an increased coding efficiency of 42.7% in case of a UMTS input signal S with 5 MHz bandwidth and 5.6dB PAPR for the combined pulse width modulated signal SPWM=SPWM1+SPWM2 compared to the single pulse width modulated signals SPWM1, SPWM2, having a coding efficiency of 11.98% only. For an explanation of the principle of cancelation of unwanted signal components, it is assumed that each output signal SPWM1 and SPWM2 of the first and second pulse width modulator PWM1 and PWM2 can be represented as a sum of fundamentals, harmonics and inter-modulation products of the input signal S and the respective reference signal SR and phase shifted reference signal SRPS. By adding the output signals SPWM1 and SPWM2, the inter-modulation products at the frequencies $k*fr \pm n*fc$, where fr is the repetition rate of the reference signal, fc is the carrier frequency of the input signal, n is a integer $\geq 0$ and k is an odd integer >0, superpose destructively. This results in the example from the fact, that an assumed used phase shift of 180° of the phase shifted reference signal SRPS for the second pulse width modulator PWM2 results in a reference signal that is inverted compared to the reference signal SR for the first pulse width modulator PWM1, which holds e.g. for triangular or sinusoidal reference signals. This means that all inter-modulation terms of the second pulse width modulated signal SPWM2 that refer to a term with an odd exponent of the reference signal SRPS, are inverted compared to the corresponding term of the first pulse width modulated signal SPWM1. Adding these two signals erases the corresponding terms.

For the simulation of the spectrum plot of the power spectral density of the combined first and second pulse width modulated signals SPWM1 and SPWM2 depicted in fig. 7, a phase shift of 180° has been chosen for the phase shift between the reference signal SR of the first pulse width modulator PWM1, and the phase shifted reference signal SRPS of the second pulse width modulator PWM2. However, also phase shifts different than 180° lead to fundamentals and harmonics of the reference signals cancelling out each other at least partially and can thus be used in embodiments of the invention.

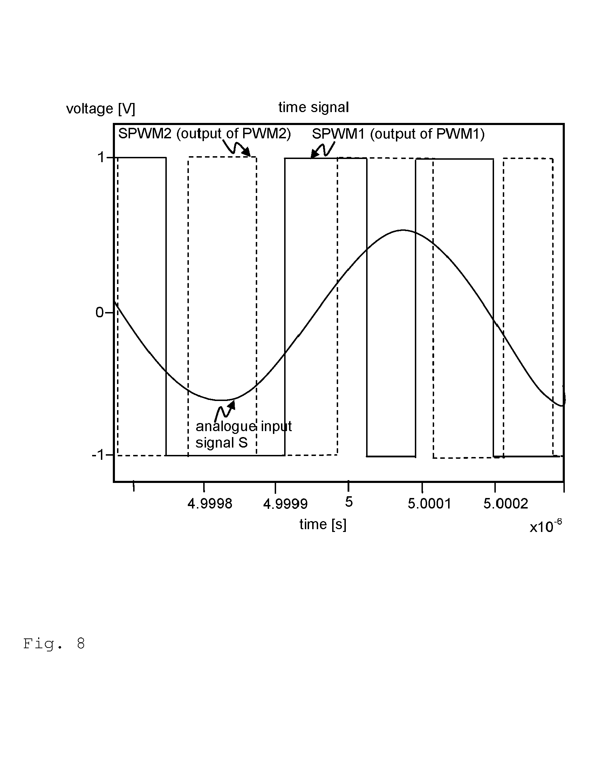

Fig. 8 shows in the time domain an analogue input signal S, a first pulse width modulated signal SPWM1 generated in a first pulse width modulator PWM1 with a reference signal SR, and a second pulse width modulated signal SPWM2 generated in a second pulse width modulator PWM2 with a phase shifted reference signal SRPS as e.g. depicted schematically in the upper and lower diagrams in fig. 4 and described above.

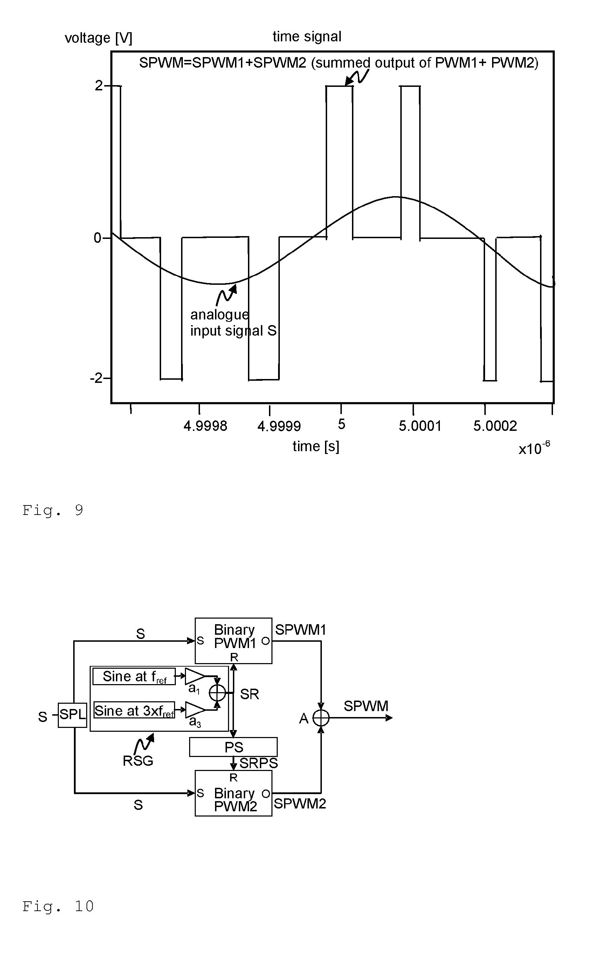

Fig. 9 corresponds to the diagram in fig. 8 with the difference, that the sum SPWM of the output signals SPWM1 and SPWM2 is shown. Thus, fig. 9 shows in the time domain the analogue input signal S, and the sum SPWM of the first pulse width modulated signal SPWM1 generated in a first pulse width modulator PWM1 with a reference signal SR and a second pulse width modulated signal SPWM2 generated in a second pulse width modulator PWM2 with a phase shifted reference signal SRPS as e.g. depicted schematically in the upper and lower diagrams in fig. 4 and described above. It can be seen that the sum SPWM of the output signals SPWM1 and SPWM2 is a ternary signal.

In order to prevent any signal distortions by the pulse width modulation process, the reference signal need to have linear transitions, as e.g. sawtooth or triangular signals. However, the generation of a linear reference signal at radio frequencies in the low GHz range is very complicated and costly because of its high frequency spectral components. The problem can be circumvented by means of the embodiment of the invention depicted in fig. 10, i.e. by using an approximation of a linear reference signal. By this means a linear reference signal is approximated by two or more phase locked sinusoidals whose frequencies are odd integer multiples of the desired reference signal repetition frequency and whose power levels are adjusted such, that the composite signal of these sinusoidals approximate best a linear reference signal within a given amplitude range. In fig. 10 an exemplary application of the approximation of a linear reference waveform generation limited to two sinusoidals is shown.

Fig. 10 schematically shows exemplarily a transmitter for signal modulation of an input signal comprising two pulse width modulators using sinusoidals for approximation of a triangular reference signal according to an embodiment of the invention.

The Fourier series representation of a triangular reference signal is as follows:

$$r_{triangle}(t) = \frac{8}{\pi^2} \sum_{n=1}^{\infty} (-1)^{(n+1)} \frac{\sin((2n-1)\overline{\omega}t)}{(2n-1)^2}$$

$$= \frac{8}{\pi^2} \left( \sin(\overline{\omega}t) - \frac{1}{9}\sin(3\overline{\omega}t) + \frac{1}{25}\sin(5\overline{\omega}t) - ... \right)$$

$$= a_1 \cdot \sin(\overline{\omega}t) + a_3 \cdot \sin(3\overline{\omega}t) + ... + a_{2n-1} \cdot \sin((2n-1)\overline{\omega}t)$$

Thus, a triangular reference signal can be approximated e.g. by a first sinusoidal with a frequency $\overline{\omega}$ weighted with a factor $a_1$, and a second sinusoidal with a frequency $3\overline{\omega}$ weighted with a factor $a_3$.

As the embodiment in fig. 10 in principle corresponds to the embodiment depicted in fig. 3, only the differences are described in the following.

The reference signal generator RSG comprises two oscillators for generation of a sinusoidal at a frequency corresponding to the reference signal repetition frequency, and for generation of a sinusoidal at a frequency corresponding to three times the reference signal repetition frequency. The two sinusoidals are weighted with a factor $a_1$ and $a_3$ respectively e.g. as given in the formula above, and added afterwards resulting in a reference signal SR.

All further steps of a pulse width modulation are as described above under fig. 3.

If a signal modulation according to the invention shall be applied for a switching power amplifier concept, ternary signals need to be amplified. Thus, in the following a transmitter comprising switching power amplifiers appropriate for amplification of ternary signals is described. Small input signal values of an input signal S, as e.g. depicted in fig. 3, will cause very short pulses in the ternary discrete pulse width modulated signal SPWM. This is a crucial problem for a switching power amplifier, because it has only a limited switching speed. Therefore, very short pulses in the ternary pulse width modulated signal SPWM are distorted by the switching power amplifier, deteriorating the performance of the transmission, as e.g. Error Vector Magnitude (EVM) or Adjacent Channel Leakage Power Ratio (ACLR).

Thus, according to an embodiment of the invention, instead of combining the two pulse width modulated signals SPWM1 and SPWM2 directly after the pulse width modulators PWM1 and PWM2 as depicted in fig. 3, the pulse width modulated signals SPWM1 and SPWM2 are amplified separately and combined afterwards to a ternary discrete signal. Thus, the switching transistors in the power amplifier do not need to amplify very short pulses. Short pulses occur only by the combination of the two amplified pulse width modulated signals.

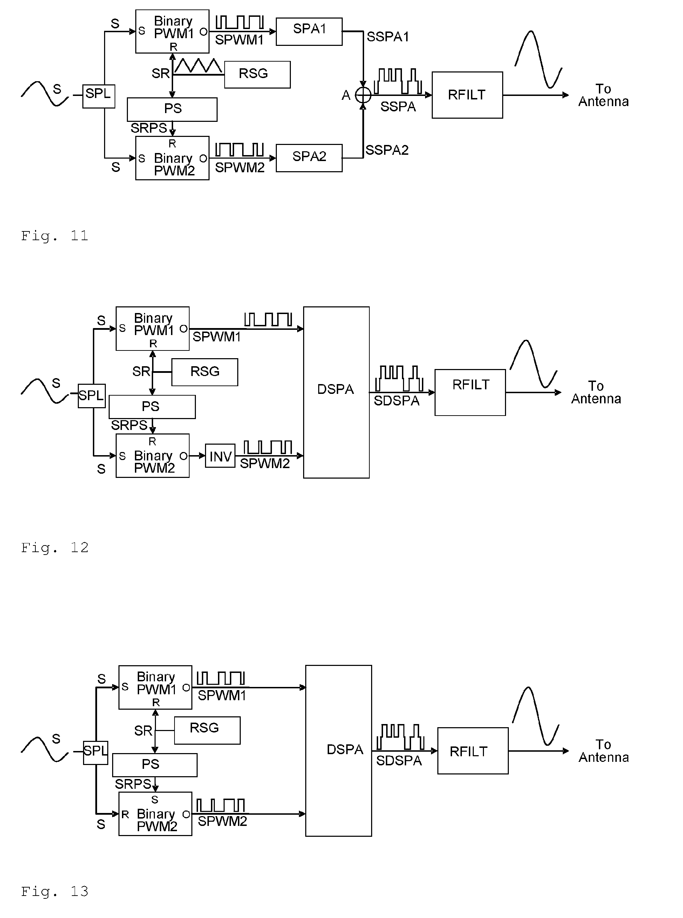

The separate amplification of the two pulse width modulated signals SPWM1 and SPWM2 can be achieved either by using separate switching power amplifiers and combination of the two amplified pulse width modulated signals afterwards as depicted in fig. 11 and described below, or by using a differential switching power amplifier as depicted in figs. 12 and 13 and described below.

Fig. 11 schematically shows exemplarily a transmitter comprising two pulse width modulators for signal modulation of an input signal and two switching power amplifiers for amplification of modulated signals according to an embodiment of the invention.

As the embodiment in fig. 11 in principle corresponds to the embodiment depicted in fig. 3, only the differences are described in the following.

The output of the first pulse width modulator PWM1 is connected to an input of a first switching power amplifier SPA1, and the output of the second pulse width modulator PWM2 is connected to an input of a second switching power amplifier SPA2.

An output of the first switching power amplifier SPA1 is connected to the first input of the adder A, and an output of the second switching power amplifier SPA1 is connected to the second input of the adder A.

The output of the adder A is connected to an input of a reconstruction filter RFILT, and an output of the reconstruction filter RFILT is connected to an antenna system.

In the first switching power amplifier SPA1, said first pulse width modulated signal SPWM1, which is a binary pulse width modulated signal, is amplified resulting in an amplified copy SSPA1 of the first pulse width modulated signal SPWM1.

In the second switching power amplifier SPA2, said second pulse width modulated signal SPWM2, which is a binary pulse width modulated signal, is amplified resulting in an amplified copy SSPA2 of the second pulse width modulated signal SPWM2.

The amplified copy SSPA1 of the first pulse width modulated signal SPWM1, and the amplified copy SSPA2 of the second pulse width modulated signal SPWM2 are added in the adder A resulting in a ternary signal SSPA.

The ternary signal SSPA is then filtered in a reconstruction filter RFILT preferably of low pass or band pass type for converting the ternary signal SSPA into an analogue signal, which is an amplified copy of the input signal S if signal distortions are corrected by a pre-emphasis of the input signal S. Said ternary signal SSPA corresponds to an amplified copy of a ternary pulse width modulated signal SPWM as e.g. depicted in fig. 9.

Thus, according to the embodiment of the invention the two output signals of the two pulse width modulators SPWM1 and SPWM2 are amplified separately in two switching power amplifiers SPA1 and SPA2, as it is easier to amplify binary pulse width modulated signals than ternary pulse width modulated signals.

Fig. 12 schematically shows exemplarily a transmitter comprising two pulse width modulators for signal modulation of an input signal, an inverter and a differential switching power amplifier for amplification of modulated signals according to an embodiment of the invention.

As the embodiment in fig. 12 in principle corresponds to the embodiment depicted in fig. 3, only the differences are described in the following.

The output of the first pulse width modulator PWM1 is connected to a first input of a differential switching power amplifier DSPA, and the output of the second pulse width modulator PWM2 is connected via a signal inverter INV to a second input of the differential switching power amplifier DSPA.

An output of the differential switching power amplifier DSPA is connected to an input of a reconstruction filter RFILT, and an output of the reconstruction filter RFILT is connected to an antenna system.

The first pulse width modulated signal SPWM1 is sent to a first input of the differential switching power amplifier DSPA.

The second pulse width modulated signal is inverted in the signal inverter INV resulting in an inverted second pulse width modulated signal SPWM2. The inverted second pulse width modulated signal SPWM2 is sent to a second input of the differential switching power amplifier DSPA.

In the embodiment depicted in fig. 12, for amplification of the two binary pulse width modulated signals, a differential switching power amplifier DSPA is used. The two inputs of the differential switching amplifier DSPA are fed with the first pulse width modulated signal SPWM1, and with the inverted second pulse width modulated signal SPWM2. Due to the differential operation, the differential switching power amplifier DSPA amplifies separately the two inputs and inherently subtracts them. Thus, for this approach, one of the pulse width modulated output signals needs to be inverted, which is the reason that the binary pulse width modulated signal resulting from the second pulse width modulator PWM2 must be inverted in the signal inverter INV.

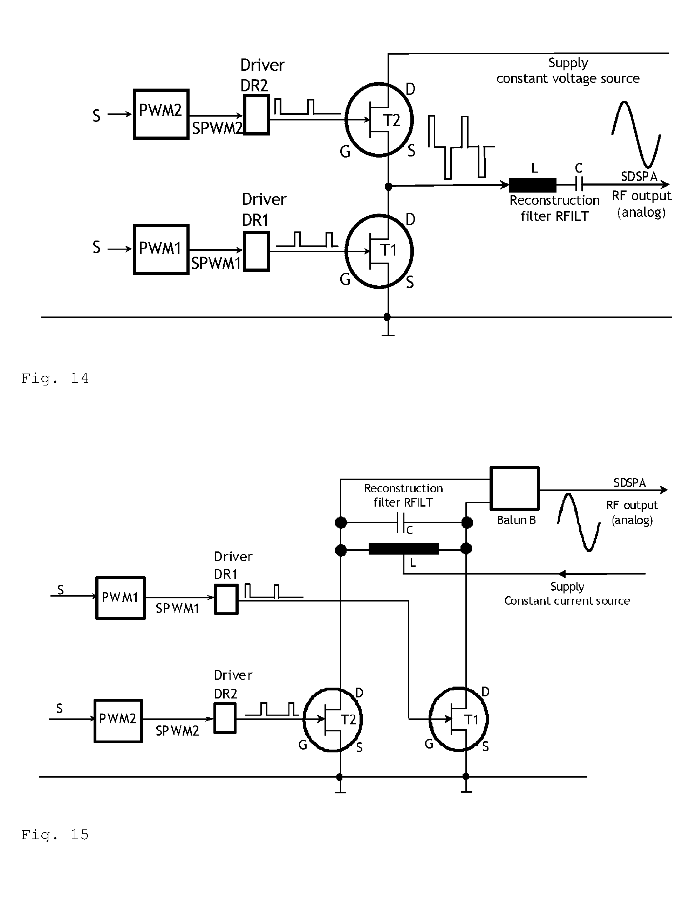

Two examples for an implementation of such a differential switching power amplifier are depicted in figs. 14 and 15, and described below.

The amplification of the first pulse width modulated signal SPWM1, and the inverted second pulse width modulated signal SPWM2 results in a ternary signal SDSPA. Said ternary signal SDSPA corresponds to an amplified copy of a ternary pulse width modulated signal as e.g. depicted in fig. 9.

The ternary signal SDSPA is then filtered in a reconstruction filter RFILT preferably of low pass or band pass type for converting the ternary signal SDSPA into an analogue signal.

Thus, according to the embodiment of the invention, the two output signals of the two pulse width modulators PWM1 and PWM2 are amplified in a differential switching power amplifier DSPA, as this is easier than a direct amplification of ternary pulse width modulated signals.

Fig. 13 schematically shows exemplarily a transmitter comprising two pulse width modulators for signal modulation of an input signal, and a differential switching power amplifier for amplification of modulated signals according to an embodiment of the invention.

In the embodiment of the invention using a differential switching power amplifier DSPA for amplification of two binary pulse width modulated signals depicted in fig. 13, instead of introducing an inverter, the inputs of one pulse width modulator PWM1 or PWM2 can be exchanged, i.e. the reference signal input, marked with 'R' in fig. 13, and the desired signal input, marked with 'S' in fig. 13, of one pulse width modulator PWM1 or PWM2 are exchanged with each other, which is equivalent to an inversion of the respective pulse width modulated signal.

Thus, the transmitter depicted in fig. 13 in principle corresponds to the transmitter depicted in fig. 12, with the difference, that no inverter INV is used, but instead the inputs for the input signal S and the phase shifted reference signal SRPS of the second pulse width modulator PWM2 are exchanged.

In an alternative of the embodiment, in case the pulse width modulators PWM1 and PWM2 provide differential outputs, the inverted output of one pulse width modulator PWM1 or PWM2 can be used instead of exchanging its input ports.

Fig. 14 schematically shows a differential switching power amplifier architecture relying on a voltage switched circuit topology according to the state of the art.

In fig. 14, the principle concept of a differential switching power amplifier system according to the state-of-the-art based on voltage switching is shown exemplarily, which can in principle be used in the respective embodiments described above and below in figs. 12, 13, 17, 18 and 20. Said differential switching power amplifier system comprises a first and a second pulse width modulator PWM1, PWM2 with inputs for reception of a digital or analogue radio frequency input signal S. An output of the first and the second pulse width modulator PWM1 and PWM2 respectively is connected to an input of a first and a second driver DR1 and DR2 respectively.

An output of the driver DR1 is connected to a gate of a first transistor T1, and an output of the driver DR2 is connected to a gate of a second transistor T2.

A source of the first transistor T1 is connected to ground, and a source of the second transistor T2 is connected to a drain of the first transistor T1.

The drain of the first transistor T1 and the source of the second transistor T2 are connected to an RF output via a reconstruction filter RFILT that comprises an inductor L and a capacitor C in series. There are variants of the L-C filter topology which however are of no importance for the invention as disclosed.

A drain of the second transistor T2 is connected to a supply of a constant voltage source.

In a method for signal amplification using a differential voltage switching power amplifier system according to the state-of-the-art as shown in fig. 14, digital or analogue RF input signals S are sent to the pulse width modulators PWM1 and PWM2. In the pulse width modulators PWM1 and PWM2, the digital or analogue RF input signals S are converted into a first and a second binary pulse width modulated signal SPWM1 and SPWM2 respectively as described above under fig. 4 by means of comparison of the input signals S with two different reference signals SR and SRPS. The first and second binary pulse width modulated signal SPWM1 and SPWM2 respectively with binary amplitude levels is provided at the output of the pulse width modulator PWM1 and PWM2 respectively.

Said first and second binary pulse width modulated signals SPWM1 and SPWM2 are sent to the driver DR1 and DR2 respectively. The driver DR1 generates first driver signals based on the first binary pulse width modulated signal SPWM1, and the driver DR2 generates second driver signals based on inverting the second binary pulse width modulated signal SPWM2.

In an alternative, instead of inverting the second binary pulse width modulated signal SPWM2, the reference signal input, and the desired signal input of the second pulse width modulator PWM2 are exchanged as described under fig. 13.

The first driver signals are sent to the gate of the first transistor T1, and the second driver signals are sent to the gate of the second transistor T2. If the output signal of the first driver DR1 is low, and the output signal of the second driver DR2 is high, then the voltage at the drain of the first transistor T1, and at the source of the second transistor T2 respectively is high, i.e. $V_{Hamp}$. If the output signal of the first driver DR1 is high, and the output signal of the second driver DR2 is low, then the voltage at the drain of the first transistor T1, and at the source of the second transistor T2 respectively is low, i.e. $V_{Lamp}$. If the output signal of both the first driver DR1 and the second driver DR2 is low, then the voltage at the drain of the second transistor T2, and at the source of the first transistor T1 respectively shall be $(V_{Hamp}+V_{Lamp})/2$.

The described amplifier architecture with two transistors T1, T2 is just an example, and in alternative architectures, more than two transistors are used, which has however no influence on the invention. Such alternative architectures are e.g. multibit architectures, using two transistors more per each bit more.

The gate driving signal for transistor T2 is referenced to the source of T2. As the source of T2 is connected to the RF output, this source potential is floating. For transistor T1 the source potential is connected to ground, i.e. it is static

The capacitor C and the inductor L together build exemplarily a reconstruction filter RFILT used to generate from amplified ternary pulse width modulated signals smooth analogue output signals that are provided at the RF output.

Fig. 15 schematically shows a differential switching power amplifier architecture relying on a current switched circuit topology according to the state of the art.

In fig. 15, a differential switching power amplifier system according to the state-of-the-art based on current switching is shown, which can in principle be used in the respective embodiments described above and below in figs. 12, 13, 17, 18 and 20. Said differential switching power amplifier system comprises a first and a second pulse width modulator PWM1, PWM2 with inputs for reception of a digital or analogue radio frequency input signal S. An output of the first and the second pulse width modulator PWM1 and PWM2 respectively is connected to an input of a first and a second driver DR1 and DR2 respectively.

An output of the driver DR1 is connected to the gate of a first transistor T1, and an output of the driver DR2 is connected to the gate of a second transistor T2.

Both a source of the first transistor T1 and a source of the second transistor T2 are connected to ground.

A drain of the first transistor T1 is connected to a first input of an inductor L and to a first input of a capacitor C, and a drain of the second transistor T2 is connected to a second input of the inductor L and to a second input of the capacitor C. The capacitor C and the inductor L build together a reconstruction filter RFILT. There are variants of the L-C filter topology which however are of no importance for the invention as disclosed.

A supply of a constant current source is connected to a third input of the inductor L.

Furthermore, the drain of the first transistor T1 is connected to a first input of a balun B, and the drain of the second transistor T2 is connected to a second input of the balun B. The balun B transforms a balanced input signal to a single ended signal. At the balun's output an analogue RF output signal is provided.

Preferably, the drivers DR1, DR2 and the transistors T1 and T2 are fabricated in Gallium Nitride (GaN) technology.

In a method for signal amplification using a differential current switching power amplifier system according to the state-of-the-art as shown in fig. 15, digital or analogue RF input signals S are sent to the pulse width modulators PWM1 and PWM2.

In the pulse width modulators PWM1 and PWM2, the digital or analogue RF input signals S are converted into a first and a second binary pulse width modulated signal SPWM1 and SPWM2 respectively as described above under fig. 4 by means of comparison of the input signals S with two different reference signals SR and SRPS, and using a so-called sample-and-hold output. The first and second binary pulse width modulated signal SPWM1 and SPWM2 respectively is provided at the output of the pulse width modulator PWM1 and PWM2 respectively.

Said first and a second binary pulse width modulated signals SPWM1 and SPWM2 are sent to the driver DR1 and DR2 respectively. The driver DR1 generates first driver signals based on the first binary pulse width modulated signal SPWM1, and the driver DR2 generates second driver signals based on inverting the second binary pulse width modulated signal SPWM2.

In an alternative, instead of inverting the second binary pulse width modulated signal SPWM2, the reference signal input, and the desired signal input of the second pulse width modulator PWM2 are exchanged as described under fig. 13.

The first driver signals are sent to the gate of the first transistor T1, and the second driver signals are sent to the gate of the second transistor T2. The signal generation by means of the first and second transistor T1 and T2 is similar as described above under fig. 14. The described amplifier architecture with two transistors T1, T2 is just an example, and in alternative architectures, more than two transistors are used, which has however no influence on the invention. Such alternative architectures are e.g. multibit architectures, using two transistors more per each bit more.

In the first transistor T1 and in the second transistor T2, the first driver signals and the second driver signals respectively are amplified resulting in first and a second amplifier signals.

The capacitor C and the inductor L build together an exemplary reconstruction filter RFILT used to generate smooth analogue signals out of the first and the second amplifier signals.

The smoothed first and second analogue signals are sent to the balun B, in which the smoothed first and second analogue signals are added together, thus removing DC distortions that have been picked up along the way. In other words, the balun B converts balanced signals to unbalanced signals. The unbalanced RF output signals are provided at the output of the balun B.

Using a differential switching power amplifier as described above has several advantages in comparison to the approach of separate amplification of the two pulse width modulated signals SPWM1 and SPWM2 using separate switching power amplifiers. Since only one switching power amplifier is used, it achieves higher energy efficiency.

The upper and lower single pulse width modulators PWM1 and PWM2 switch on and off the respective switching transistors T1 and T2 of the differential switching power amplifier e.g. depicted in fig. 14 or 15. In general, transfer characteristics, i.e. the different states, of a differential switching power amplifier are given by the following table.

| State | SPWM1 | SPWM2 | SDSPA |
|---|---|---|---|
| 1 | $V_L$ | $V_L$ | $(V_L + V_H)/2$ |
| 2 | $V_L$ | $V_H$ | $V_H$ |
| 3 | $V_H$ | $V_L$ | $V_L$ |
| 4 | $V_H$ | $V_H$ | $(V_L + V_H)/2$ |

As can be seen, the output SDSPA of the differential switching power amplifier is $(V_L+V_H)/2$ when both pulse width modulated signals SPWM1 and SPWM2 are either voltage-low $V_L$ or voltage-high $V_H$, i.e. both switching transistors T1 and T2 of the differential switching power amplifier are switched on or off, respectively. Most of the power dissipation of the differential switching power amplifier is caused by the on-resistance of the switching transistors T1 and T2. Thus, switching on both switching transistors T1 and T2, which corresponds to state 4 in the upper table, to produce a voltage $(V_L+V_H)/2$ at the differential switching power amplifier output results in a high power dissipation and should be avoided.

In an embodiment according to the invention, a so-called H-Bridge is employed as amplifier stage in order to circumvent the problem of the high power dissipation.

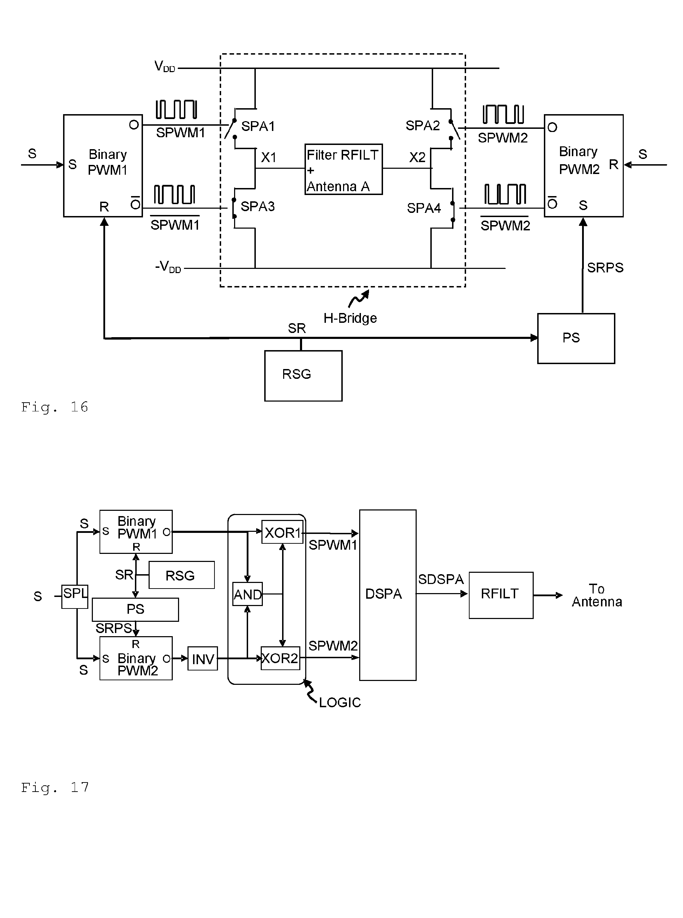

Fig. 16 schematically shows exemplarily a transmitter comprising two pulse width modulators for signal modulation of an input signal, and a H-Bridge power amplifier according to an embodiment of the invention.

The transmitter comprises a first and a second pulse width modulator PWM1, PWM2, and a H-bridge power amplifier. The H-bridge power amplifier in turn comprises four switching power amplifiers SPA1-SPA4, and a processing unit with a reconstruction filter RFILT, and an antenna A.

A first output O of the first pulse width modulator PWM1 is connected to the first switching power amplifier SPA1, and a second output $\overline{O}$ of the first pulse width modulator PWM1 is connected to the third switching power amplifier SPA3.

The first and the third switching power amplifier SPA1 and SPA3 are connected to a first input of the processing unit with the reconstruction filter RFILT, and the antenna A.

A drain of the first switching power amplifier SPA1 is connected to a positive power supply $V_{DD}$, and a source of the third switching power amplifier SPA3 is connected to a negative power supply $-V_{DD}$.

A first output O of the second pulse width modulator PWM2 is connected to the second switching power amplifier SPA2, and a second output $\overline{O}$ of the second pulse width modulator PWM2 is connected to the fourth switching power amplifier SPA4.

The second and the fourth switching power amplifier SPA2 and SPA4 are connected to a second input of the processing unit with the reconstruction filter RFILT, and the antenna A.

A drain of the second switching power amplifier SPA2 is connected to the positive power supply $V_{DD}$, and a source of the fourth switching power amplifier SPA4 is connected to the negative power supply $-V_{DD}$.

An input signal S is transmitted to a signal input of the first pulse width modulator PWM1, and a reference signal SR generated in a reference signal generator RSG is fed to a reference input of the first pulse width modulator PWM1. As depicted in the upper diagram in fig. 4 and described above, a first pulse width modulated signal SPWM1 results from a comparison of the input signal S with the reference signal SR, and said first pulse width modulated signal SPWM1 is sent via the first output O to the first switching power amplifier SPA1.

Also, an inverted first pulse width modulated signal $\overline{SPWM1}$ is sent via the second output $\overline{O}$ of the first pulse width modulator PWM1 to the third switching power amplifier SPA3.

The input signal S is also transmitted to a reference signal input of the second pulse width modulator PWM2, and the reference signal SR generated in the reference signal generator RSG is phase shifted in a phase shifter PS, and a resulting phase shifted reference signal SRPS is fed to a signal input of the second pulse width modulator PWM2. As depicted in the lower diagram in fig. 4 and described above, a second pulse width modulated signal SPWM2 results from a comparison of the input signal S with the phase shifted reference signal SRPS, and said second pulse width modulated signal SPWM2 is sent via the first output O to the second switching power amplifier SPA2. Also, an inverted second pulse width modulated signal $\overline{SPWM2}$ is sent via the second output $\overline{O}$ of the second pulse width modulator PWM2 to the fourth switching power amplifier SPA4.

The signal input and the reference signal input of the second pulse width modulator PWM2 are exchanged, because the output of the H-Bridge amplifier is an amplified copy of the difference between the first pulse width modulated signal SPWM1 and the second pulse width modulated signal SPWM2, as e.g. described above under fig. 13. As an alternative, a first inverter can be inserted between the first output O of the second pulse width modulator PWM2 and the second switching power amplifier SPA2, and a second inverter can be inserted between the second output $\overline{O}$ of the second pulse width modulator PWM2 and the fourth switching power amplifier SPA4.

As a further alternative, the output O of the second pulse width modulator PWM2 can be connected to the fourth switching power amplifier SPA 4 and the output $\overline{O}$ of the second pulse width modulator PWM2 can be connected to the second pulse width modulator PWM2 SPA2.

The amplification of the first and second pulse width modulated signals SPWM1, SPWM2, and the inverted first and second pulse width modulated signal $\overline{SPWM1}$, $\overline{SPWM2}$ results in a ternary signal e.g. as depicted in fig. 9.

The H-bridge power amplifier yields a differential ternary signal, as e.g. depicted in fig. 9, between the points X1 and X2 in fig. 16, which is an amplified version of the difference between the first and second pulse width modulated signals SPWM1, SPWM2. Let denote the difference between X1 and X2 as SX. This differential ternary signal is delivered to the differential input of a processing unit with a reconstruction filter RFILT and antenna A.

Let denote the voltage-high and voltage-low of the first binary pulse width modulated signal SPWM1 by $V_h$ and $V_l$, respectively. Equivalently, the voltage-high and voltage-low of the second binary pulse width modulated signal SPWM2 by $V_h$ and $V_l$, respectively. If SPWM1 and SPWM2 equals $V_h$, then the differential signal SX between X1 and X2 equals zero. Similarly, if SPWM1 and SPWM2 equals $V_l$, then SX equals zero. If SPWM1 equals $V_h$ and SPWM2 equals $V_l$, then SX equals a positive value $V_X$. If SPWM1 equals $V_L$ and SPWM2 equals $V_H$, then SX equals $-V_X$.

In conventional state-of-the-art differential switching power amplifiers the output would be undefined, if SPWM1 and SPWM2 equal $V_L$. The H-bridge power amplifier circumvents inherently this problem. The ternary signal is then filtered in a reconstruction filter RFILT preferably of low pass or band pass type for converting the ternary signal into an analogue signal.

The H-Bridge architecture appears to be an ideally suited amplifier for distributed ternary pulse width modulated signals, i.e. for two binary pulse width modulated signal streams. The H-Bridge avoids that the two switching power amplifiers SPA1 and SPA3 are switched on at the same time, and the H-Bridge also avoids that the two switching power amplifiers SPA2 and SPA4 are switched on at the same time, as the respective switching power amplifiers are connected to the pairs of differential output ports of the two binary pulse width modulators PWM1 and PWM2.

According to a further embodiment of the invention, the problem of the high power dissipation described above is circumvented by prepending a logic circuit at the input of the differential switching power amplifier, which maps the state 4 to the state 1 in the upper table, i.e. instead of switching both switching transistors T1 and T2 in fig. 14 or 15 on, both transistors are switched off.

Fig. 17 schematically shows exemplarily a transmitter comprising two pulse width modulators for signal modulation of an input signal, an inverter, a logic circuit, and a differential switching power amplifier for amplification of modulated signals according to an embodiment of the invention.

As the embodiment in fig. 17 in principle corresponds to the embodiment depicted in fig. 12, only the differences are described in the following.

A logical circuit LOGIC comprising a first and a second element for performing an exclusive-or-operation XOR1 and XOR2, and an element for performing an and-operation AND is inserted between the first and the second pulse width modulators PWM1, PWM2, and the differential switching power amplifier DSPA.

The output of the first pulse width modulator PWM1 is connected both to a first input of the first element for performing an exclusive-or-operation XOR1, and to a first input of the element for performing an and-operation AND.

The output of the second pulse width modulator PWM2 is connected via the inverter INV both to a first input of the second element for performing an exclusive-or-operation XOR2, and to a second input of the element for performing an and-operation AND.

An output of the element for performing an and-operation AND is connected both to a second input of the first element for performing an exclusive-or-operation XOR1, and to a second input of the second element for performing an exclusive-or-operation XOR2.

An output of the first element for performing an exclusive-or-operation XOR1 is connected to the first input of the differential switching power amplifier DSPA, and an output of the second element for performing an exclusive-or-operation XOR2 is connected to the second input of the differential switching power amplifier DSPA.

If both input values to the logical circuit LOGIC are voltage-high $V_H$, the output value of the element for performing an and-operation AND is also voltage-high $V_H$. Thus, both input values of both elements for performing an exclusive-or-operation XOR1 and XOR2 are voltage-high $V_H$, which leads to both output values SPWM1 and SPWM2 of the logical circuit LOGIC being voltage-low $V_L$.

Thus, said logical circuit LOGIC maps the state 4 to the state 1 in the upper table, i.e. instead of switching both switching transistors T1 and T2 in fig. 14 or 15 on, both transistors are switched off.

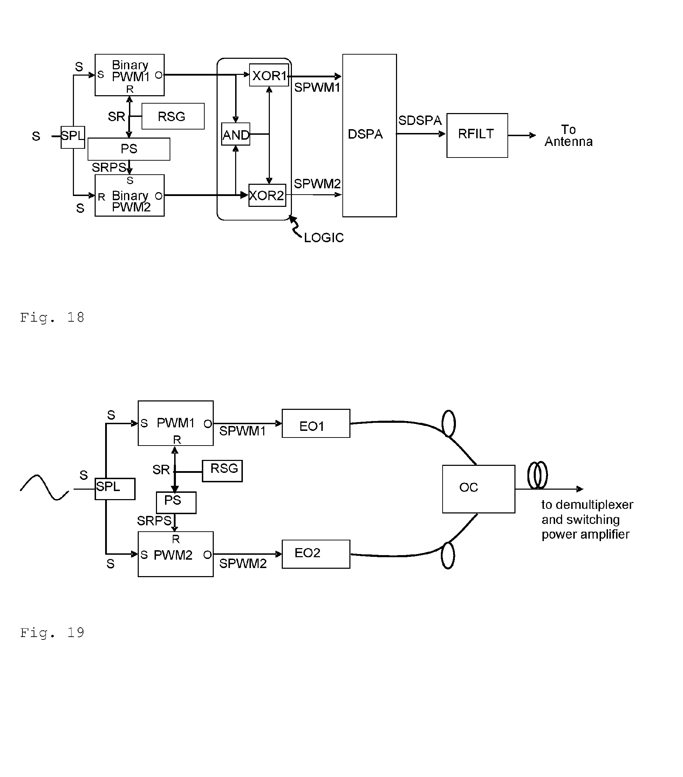

Fig. 18 schematically shows exemplarily a transmitter comprising two pulse width modulators for signal modulation of an input signal, a logic circuit, and a differential switching power amplifier for amplification of modulated signals according to an embodiment of the invention.

The embodiment in fig. 18 corresponds to the embodiment depicted in fig. 17, with the difference, that instead of introducing an inverter INV, the reference signal input, marked with 'R' in fig. 17, and the desired signal input, marked with 'S' in fig. 17, of the second pulse width modulator PWM2 are exchanged with each other, which is equivalent to an inversion of the respective pulse width modulated signal.

In further embodiments of the invention, instead of using binary switching power amplifiers or differential switching power amplifiers as described above, a ternary amplifier, i.e. an amplifier that can handle ternary, i.e. 3-level, input signals is used. E.g. if the pulse width modulators PWM1 and PWM2 in fig. 3 provide an alphabet voltage-high $V_H$ and voltage-low $V_L$, the ternary switching amplifier must be capable to process input levels $2*V_H$, $V_H+V_L$ and $2*V_L$ of the combined pulse width modulated signal SPWM. E.g. for $V_H$=1V and $V_L$=-1V this means that the ternary amplifier must be capable to process a ternary switching signal with levels +2V, 0V and -2V.

Fig. 19 schematically shows exemplarily a transmitter comprising two pulse width modulators for signal modulation of an input signal, two electro-optical converters and an optical combiner for optical transmission of pulse width modulated signals according to an embodiment of the invention.

The transmitter comprises a splitter or coupler SPL, a first and a second pulse width modulator PWM1, PWM2, a reference signal generator RSG, a phase shifter PS, a first and a second electro-optical converter EO1, EO2, and an optical combiner OC.

An input signal S is duplicated by means of the splitter or coupler SPL. As in the embodiment in fig. 19 only the functionality of a splitter is required, the usage of a splitter SPL is preferred.

The input signal S is transmitted to a signal input of the first pulse width modulator PWM1, and a reference signal SR is fed to a reference input of the first pulse width modulator PWM1. As depicted in the upper diagram in fig. 4 and described above, a first pulse width modulated signal SPWM1 results from a comparison of the input signal S with the reference signal SR, and said first pulse width modulated signal SPWM1 is sent to an input of the first electro-optical converter EO1.

In the first electro-optical converter EO1, said first pulse width modulated signal SPWM1, which is a binary pulse width modulated signal, is converted from an electrical signal to an optical signal, and transmitted via an optical connection to a first input of the optical combiner OC.

The input signal S is also transmitted to a signal input of the second pulse width modulator PWM2, and a phase shifted reference signal SRPS is fed to a reference input of the second pulse width modulator PWM2. As depicted in the lower diagram in fig. 4 and described above, a second pulse width modulated signal SPWM2 results from a comparison of the input signal S with the phase shifted reference signal SRPS, and said second pulse width modulated signal SPWM2 is sent to an input of the second electro-optical converter EO2.

In the second electro-optical converter EO2, said second pulse width modulated signal SPWM2, which is a binary pulse width modulated signal, is converted from an electrical signal to an optical signal, and transmitted via an optical connection to a second input of the optical combiner OC.

The electro-optical converters EO1, EO2 can either work on the same optical frequency or on different optical frequencies.

From the optical combiner, the first and second optical pulse width modulated signals SPWM1, SPWM2 are transmitted via an optical connection to a demultiplexer and to switching power amplifiers SPA1 and SPA2 as depicted in fig. 11 and described above. The further signal processing is as depicted in fig. 11 and described above. In fig. 19, the demultiplexer and the switching power amplifiers are not depicted for the sake of simplicity.

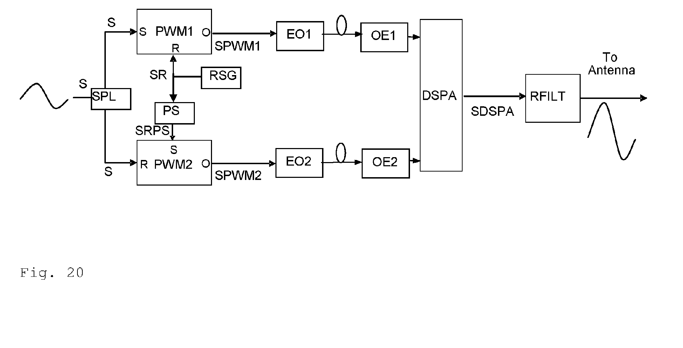

Fig. 20 schematically shows exemplarily a transmitter according to fig. 13, with additionally two electro-optical converters and two opto-electrical converters for optical transmission of pulse width modulated signals to the differential switching power amplifier according to an embodiment of the invention.

As the embodiment in fig. 20 in principle corresponds to the embodiment depicted in fig. 13, only the differences are described in the following.

The first pulse width modulated signal SPWM1, which is a binary pulse width modulated signal, is transmitted from the first pulse width modulator PWM1 to the first electro-optical converter EO1, and is converted from an electrical signal to an optical signal in the first electro-optical converter EO1. The first optical pulse width modulated signal SPWM1 is then transmitted via an optical connection to the first opto-electrical converter OE1, and is converted from an optical signal to an electrical signal in the first opto-electrical converter OE1. The first opto-electrical converter OE1 is in turn connected to a first input of the differential switching power amplifier DSPA.

The second pulse width modulated signal SPWM2, which is a binary pulse width modulated signal, is transmitted from the second pulse width modulator PWM2 to the second electro-optical converter EO2, and is converted from an electrical signal to an optical signal in the second electro-optical converter EO2. The second optical pulse width modulated signal SPWM2 is then transmitted via an optical connection to the second opto-electrical converter OE2, and is converted from an optical signal to an electrical signal in the second opto-electrical converter OE2. The second opto-electrical converter OE2 is in turn connected to a second input of the differential switching power amplifier DSPA.

The electro-optical converters EO1, EO2 can either work on the same optical frequency or on different optical frequencies.

The further processing of the signals is as described above in fig. 13.

As an example for an application of a transmitter according to the invention, a base station in a wireless communication network can comprise a transmitter according to one of the embodiments described above, and an antenna network for transmission of signals over an air interface.

**Claims**

1. A method for signal modulation of an input signal (S) using pulse width modulators (PWM1, PWM2), wherein

   • the input signal (S) is modulated in said pulse width modulators (PWM1, PWM2) by means of reference signals (SR, SRPS) resulting in pulse width modulated signals with two levels (SPWM1, SPWM2),
   • and at least one of a group of fundamentals and harmonics of a first reference signal of said reference signals (SR) and intermodulation products of said first reference signal (SR) and the input signal (S) comprised in a first pulse width modulated signal of said pulse width modulated signals with two levels (SPWM1) at least partially superpose destructively with at least one of a group of fundamentals and harmonics of a second reference signal of said reference signals (SRPS) and intermodulation products of said second reference signal (SRPS) and the input signal (S) comprised in a second pulse width modulated signal of said pulse width modulated signals with two levels (SPWM2).

2. A method according to claim 1, wherein the reference signals (SR, SRPS) of the pulse width modulators (PWM1, PWM2) are phase shifted among each other.

3. A method according to claim 2, wherein the reference signals (SR, SRPS) of the pulse width modulators (PWM1, PWM2) are phase shifted by a phase of 180° among each other.

4. A method according to claim 2 or 3, wherein the reference signals (SR, SRPS) of the pulse width modulators (PWM1, PWM2) are phase shifted among each other using at least one of a group of a phase shifter (PS) and a delay element.

5. A method according to any of the preceding claims,
   wherein at least one of the reference signals (SR, SRPS) of the pulse width modulators (PWM1, PWM2) is generated by combination of at least two sinusoidal signals whose frequencies are odd integer multiples of the repetition frequency of said at least one of the reference signals (SR, SRPS).

6. A method according to any of the preceding claims,
   wherein

   • said pulse width modulated signals with two levels (SPWM1, SPWM2) are amplified in at least one switching power amplifier (SPA1, SPA2, DSPA) resulting in a multi-level signal with at least three levels (SSPA, SDSPA),
   • and said multi-level signal with at least three levels (SSPA, SDSPA) is converted to an analogue signal.

7. A method according to claim 6, wherein

   • the first pulse width modulated signal (SPWM1) of said pulse width modulated signals with two levels (SPWM1, SPWM2) is amplified in a first switching power amplifier (SPA1) of said at least one switching power amplifier (SPA1, SPA2) resulting in a first amplified modulated signal (SSPA1),
   • the second pulse width modulated signal (SPWM2) of said pulse width modulated signals with two levels (SPWM1, SPWM2) is amplified in a second switching power amplifier (SPA2) of said at least one switching power amplifier (SPA1, SPA2) resulting in a second amplified modulated signal (SSPA2),
   • and the first amplified modulated signal (SSPA1) and the second amplified modulated signal (SSPA2) are combined resulting in said multi-level signal with three levels (SSPA).

8. A method according to claim 6, wherein the first pulse width modulated signal (SPWM1) and the second pulse width modulated signal (SPWM2) of said pulse width modulated signals with two levels (SPWM1, SPWM2) are amplified in a differential switching power amplifier (DSPA).

9. A method according to claim 8, wherein one of said first pulse width modulated signal (SPWM1) and said second pulse width modulated signal (SPWM2) is inverted before amplification in said differential switching power amplifier (DSPA) .

10. A method according to claim 8 or 9, wherein a state in which both switching transistors of the differential switching power amplifier (DSPA) are switched on is changed to a state in which both switching transistors of the differential switching power amplifier (DSPA) are switched off by means of a logic circuit (LOGIC).

11. A method according to claim 8 or 9, wherein in one of said pulse width modulators (PWM1, PWM2), the input signal (S) is fed to an input for a reference signal, and the reference signal (SR, SRPS) is fed to an input for a data signal.

12. A method according to claim 6, wherein

   • the first pulse width modulated signal (SPWM1) of said pulse width modulated signals (SPWM1, SPWM2), and an inverted first pulse width modulated signal ($\overline{SPWM1}$) are generated in a first pulse width modulator (PWM1) of said pulse width modulators (PWM1, PWM2),
   • the second pulse width modulated signal (SPWM2) of said pulse width modulated signals (SPWM1, SPWM2), and an inverted second pulse width modulated signal ($\overline{SPWM2}$) are generated in a second pulse width modulator (PWM2) of said pulse width modulators (PWM1, PWM2),
   • and the first pulse width modulated signal (SPWM1), the inverted first pulse width modulated signal ($\overline{SPWM1}$), the second pulse width modulated signal (SPWM2), and the inverted second pulse width modulated signal ($\overline{SPWM2}$) are amplified using a H-bridge power amplifier.

13. A method according to any of the preceding claims, wherein at least one pulse width modulated signal (SPWM1, SPWM2) is converted from an electrical signal to an optical signal in at least one electro-optical converter (EO1, EO2), transmitted over at least one optical connection, and converted from an optical signal to an electrical signal in at least one opto-electrical converter (OE1, OE2).

14. A transmitter comprising pulse width modulators (PWM1, PWM2) for signal modulation of an input signal (S), wherein said pulse width modulators (PWM1, PWM2) are adapted to modulate the input signal (S) by means of reference signals (SR, SRPS) resulting in pulse width modulated signals with two levels (SPWM1, SPWM2) in such a way, that at least one of a group of fundamentals and harmonics of a first reference signal of said reference signals (SR) and intermodulation products of said first reference signal (SR) and the input signal (S) comprised in a first pulse width modulated signal of said pulse width modulated signals with two levels (SPWM1) at least partially superpose destructively with at least one of a group of fundamentals and harmonics of a second reference signal of said reference signals (SRPS) and intermodulation products of said second reference signal (SRPS) and the input signal (S) comprised in a second pulse width modulated signal of said pulse width modulated signals with two levels (SPWM2).

15. A base station comprising a transmitter according to claim 14 and at least one antenna network for transmission of signals over an air interface.

Fig. 1

Fig. 2

Fig. 3

Fig. 4

Power Spectral Density [dBm]

Fig. 5

Power Spectral Density [dBm]

Fig. 6

Fig. 7

Fig. 8

voltage [V]          time signal

SPWM=SPWM1+SPWM2 (summed output of PWM1+ PWM2)

analogue
input signal S

4.9998      4.9999       5        5.0001      5.0002

time [s]

x10$^{-6}$

Fig. 9

Fig. 10

Fig. 11

Fig. 12

Fig. 13

Fig. 14

Fig. 15

Fig. 16

Fig. 17

Fig. 18

Fig. 19

Fig. 20

Europäisches
Patentamt
European
Patent Office
Office européen
des brevets

**EUROPEAN SEARCH REPORT**

Application Number

EP 11 30 6719

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/146069 A1 (WU KUO-HUNG [TW] ET AL) 28 June 2007 (2007-06-28) | 1-7,14 | INV.<br>H03F3/217 |
| Y | * paragraphs [0017] - [0019], [0042]; figures 5, 6A, 6B, 8A-C * | 8-10,12, 13,15 | H03F1/26<br>H03K7/08<br>H02M7/487 |
| X | GB 2 459 304 A (NUJIRA LTD [GB]) 21 October 2009 (2009-10-21) * abstract; figures 3, 4(d) * | 1-3,5-7, 11,14 | H04B15/00 |
| Y | EP 1 447 908 A1 (SONY CORP [JP]) 18 August 2004 (2004-08-18) * abstract; figures 7,9 * | 8,9,12 | |
| Y | US 7 573 328 B2 (VIEHMANN HANS-HEINRICH [DE] ET AL) 11 August 2009 (2009-08-11) * abstract; figures 3,6 * | 10 | |
| Y | US 2004/169552 A1 (BUTLER JOEL [US]) 2 September 2004 (2004-09-02) * abstract * | 13 | |
| Y | US 2007/002943 A1 (MIDYA PALLAB [US]) 4 January 2007 (2007-01-04) * abstract * | 15 | TECHNICAL FIELDS SEARCHED (IPC)<br><br>H03F<br>H03K<br>H02M<br>H04B |

The present search report has been drawn up for all claims

| Place of search | Date of completion of the search | Examiner |
|---|---|---|
| The Hague | 7 March 2012 | Van den Doel, Jules |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 30 6719

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2012

| Patent document cited in search report | | Publication date | Patent family member(s) | | Publication date |
|---|---|---|---|---|---|
| US 2007146069 | A1 | 28-06-2007 | CN 101222207 A | | 16-07-2008 |
| | | | TW I336556 B | | 21-01-2011 |
| | | | US 2007146069 A1 | | 28-06-2007 |
| GB 2459304 | A | 21-10-2009 | AT 545984 T | | 15-03-2012 |
| | | | CN 102084592 A | | 01-06-2011 |
| | | | EP 2269306 A1 | | 05-01-2011 |
| | | | GB 2459304 A | | 21-10-2009 |
| | | | JP 2011520328 A | | 14-07-2011 |
| | | | KR 20110021776 A | | 04-03-2011 |
| | | | US 2011095837 A1 | | 28-04-2011 |
| | | | WO 2009127739 A1 | | 22-10-2009 |
| EP 1447908 | A1 | 18-08-2004 | EP 1447908 A1 | | 18-08-2004 |
| | | | JP 3894305 B2 | | 22-03-2007 |
| | | | JP 2003218647 A | | 31-07-2003 |
| | | | US 2004263244 A1 | | 30-12-2004 |
| | | | WO 03044947 A1 | | 30-05-2003 |
| US 7573328 | B2 | 11-08-2009 | DE 102008006728 A1 | | 14-08-2008 |
| | | | US 2008186089 A1 | | 07-08-2008 |
| US 2004169552 | A1 | 02-09-2004 | US 2003067348 A1 | | 10-04-2003 |
| | | | US 2004169552 A1 | | 02-09-2004 |
| | | | WO 03032483 A1 | | 17-04-2003 |
| US 2007002943 | A1 | 04-01-2007 | NONE | | |

For more details about this annex : see Official Journal of the European Patent Office, No. 12/82